# EUROPÄISCHE PATENTANMELDUNG

(11) **EP 0 971 405 A2**
(43) Veröffentlichungstag der Anmeldung: **12.01.2000**
(21) Anmeldenummer: 99116980.6
(22) Anmeldetag: 22.09.1995
(51) Int. Cl.: H01L 23/13, H01L 23/14, H01L 21/48

(54) **Verfahren zur Herstellung eines Substrates für ein Polymer Stud Grid Array**

(30) Priorität: 23.09.1994 DE 4434086
(62) Teilanmeldung aus: 95934106.6
(71) Anmelder: Siemens S.A., 1060 Bruxelles (BE); INTERUNIVERSITAIR MICRO-ELEKTRONICA CENTRUM VZW, 3001 Heverlee (BE)
(72) Erfinder: Heerman, Marcel, 9200 Merelbeke (BE); Wille, Joost, Dr., 8210 Loppem (BE); Roggen, Jean, Dr., 3560 Lummen (BE); Beyne, Eric, Dr., 3001 Leuven (BE); von Hoof, Rita, 3191 Boortmeerbeek (BE); van Puymbroeck, Jozef, 8020 Oostkamp (BE)
(74) Vertreter: Zedlitz, Peter

(57) **Zusammenfassung**

Das Verfahren umfaßt folgende Schritte:
- Herstellung des dreidimensionalen Substrats (S) aus einem elektrisch isolierenden Polymer durch Spritzgießen, derart, daß auf der Unterseite des Substrats (S) flächig angeordnete und beim Spritzgießen mitgeformte Polymerhöcker (PS) entstehen;
- ganzflächige Metallisierung des Substrats (S);
- Bildung von Außenanschlüssen (AA) auf den Polymerhöckern (PS), von Innenanschlüssen (IA1; IA2; IA3) und von Leiterzügen (LZ) durch Laserstrukturierung der Metallisierung, wobei die zumindest auf der Unterseite des Substrats (S) ausgebildeten Leiterzüge (LZ) sich zwischen den Außenanschlüssen (AA) und den Innenanschlüssen (IA1; IA2; IA3) erstrecken;
- Aufbringen einer lötbaren Endoberfläche im Kuppenbereich der Polymerhöcker (PS).
Ein derart hergestelltes Substrat (S) ermöglicht eine neue Bauform für Single-, Few- oder Multi-Chip-Module, welche die Vorteile eines Ball Grid Arrays mit den Vorteilen der MID Technologie (Moulded Interconnection Devices) vereinigt. Die Herstellung und Metallisierung der Polymerhöcker (PS) kann dabei im Rahmen der bei der MID TEchnologie ohnehin erforderlichen Verfahrensschritte, mit einem minimalen zusätzlichen Aufwand vorgenommen werden.

## Beschreibung

Integrierte Schaltkreise bekommen immer höhere Anschlußzahlen und werden dabei immer weiter miniaturisiert. Die bei dieser zunehmenden Miniaturisierung erwarteten Schwierigkeiten mit Lotpastenauftrag und Bestückung, sollen durch neue Gehäuseformen behoben werden, wobei hier insbesondere Single- Few- oder Multi-Chip-Module im Ball Grid Array Package hervorzuheben sind (DE-Z productronic 5, 1994, Seiten 54, 55). Diese Module basieren auf einem durchkontaktierten Substrat, auf welchem die Chips beispielsweise über Kontaktierdrähte oder mittels Flipchip-Montage kontaktiert sind. An der Unterseite des Substrats befindet sich das Ball Grid Array (BGA), das häufig auch als Solder Grid Array, Land Grid Array oder Solder Bump Array, bezeichnet wird. Das Ball Grid Array umfaßt auf der Unterseite des Substrats flächig angeordnete Lothöcker, die eine Oberflächenmontage auf den Leiterplatten oder Baugruppen ermöglichen. Durch die flächige Anordnung der Lothöcker, können hohe Anschlußzahlen in einem groben Raster von beispielsweise 1,27 mm realisiert werden.

Bei der sogenannten MID Technologie (MID = Moulded Interconnection Devices), werden anstelle konventioneller gedruckter Schaltungen Spritzgießteile mit integrierten Leiterzügen verwendet. Hochwertige Thermoplaste, die sich zum Spritzgießen von dreidimensionalen Substraten eignen, sind die Basis dieser Technologie. Derartige Thermoplaste zeichnen sich gegenüber herkömmlichen Substratmaterialien für gedruckte Schaltungen durch bessere mechanische, thermische, chemische, elektrische und umwelttechnische Eigenschaften aus. Bei einer speziellen Richtung der MID Technologie, der sogenannten SIL-Technik (SIL = Spritzgießteile mit integrierten Leiterzügen), erfolgt die Strukturierung einer auf die Spritzgießteile aufgebrachten Metallschicht unter Verzicht auf die sonst übliche Maskentechnik durch ein spezielles Laserstrukturierungsverfahren. In die dreidimensionalen Spritzgießteile mit strukturierter Metallisierung sind dabei mehrere mechanische und elektrische Funktionen integrierbar. Die Gehäuseträgerfunktion übernimmt gleichzeitig Führungen und Schnappverbindungen, während die Metallisierungsschicht neben der Verdrahtungs- und Verbindungsfunktion auch als elektromagnetische Abschirmung dient und für eine gute Wärmeabfuhr sorgt. Weitere Einzelheiten zur Herstellung von dreidimensionalen Spritzgießteilen mit integrierten Leiterzügen, gehen beispielsweise aus der DE-A-37 32 249 oder der EP-A-0 361 192 hervor.

Aus der US-A-5 081 520 ist ein Verfahren zum Befestigen von IC-Chips auf Substraten bekannt, bei welchem die Substrate als Spritzgießteile mit integrierten Höckern für die Befestigung der IC-Chips hergestellt werden. Nach dem Metallisieren der Höcker wird eine Verbindungsschicht aufgebracht, so daß die IC-Chips auf den Substraten befestigt werden können, wobei die Chip-Anschlußflächen mit den zugeordneten Metallisierungen der Höcker elektrisch leitend verbunden werden.

Der im Anspruch 1 angegebenen Erfindung liegt das Problem zugrunde, ein Verfahren zur Herstellung eines Substrats anzugeben, mit welchem eine neue Bauform für Single-, Few- oder Multi-Chip-Module realisiert werden kann, welche die Vorteile der MID Technologie aufweist und eine flächige Anordnung der Außenanschlüsse, wie beim Ball Grid Array ermöglicht.

Die neue Bauform ist in Anlehnung an das Ball Grid Array (BGA) als Polymer Stud Grid Array (PSGA) bezeichnet, wobei der Begriff "Polymer Stud" auf die beim Spritzgießen des Substrats mitgeformten Polymerhöcker hinweisen soll. Neben der einfachen und kostengünstigen Herstellung der Polymerhöcker beim Spritzgießen des Substrats, kann auch die Herstellung der Außenanschlüsse auf den Polymerhöckern mit minimalen Aufwand zusammen mit der bei der MID Technologie bzw. der SIL-Technik üblichen Herstellung der Leiterzüge vorgenommen werden. Durch die bei der SIL-Technik bevorzugte Laserfeinstrukturierung, können die Außenanschlüsse auf den Polymerhöckern mit hohen Anschlußzahlen in einem sehr feinen Raster realisiert werden. Hervorzuheben ist ferner, daß die Temperaturausdehnung der Polymerhöcker den Temperaturausdehnungen des Substrats und der das Modul aufnehmenden Leiterplatte entspricht. Sollten mechanische Spannungen auftreten, so ermöglichen die Polymerhöcker durch ihre elastischen Eigenschaften zumindest einen teilweisen Ausgleich. Durch die Formstabilität der auf den Polymerhöckern gebildeten Außenanschlüsse, kann auch die Sicherheit bei Reparatur und Austausch gegenüber den Ball Grid Arrays mit ihren durch Lothöcker gebildeten Außenanschlüssen erheblich gesteigert werden.

Vorteilhafte Ausgestaltungen der Erfindung sind in den Unteransprüchen angegeben.

Die Ausgestaltung nach Anspruch 2 ermöglicht eine flexible Verwendung des Substrats für Single-, Few- oder Multi-chip-Module.

Die Ausgestaltungen nach den Ansprüchen 3 und 4 ermöglichen eine versunkene Montage der Chips in Mulden der spritzgegossenen Substrate, wodurch eine extrem geringe Dicke der resultierenden Single-, Few- oder Multi-Chip-Module realisiert werden kann. Die versunkene Montage ermöglicht außerdem einen optimalen Schutz der Chips, sowie eine einfache und hermetisch dichte Verkapselung.

Die Weiterbildung nach Anspruch 5 ermöglicht eine Kontaktierung der Chips in der bewährten Drahtbond-Technik. Gemäß Anspruch 6 kann die Anbringung der Kontaktierdrähte durch die Anordnung der Innenanschlüsse auf einer Stufe der Mulde erleichtert werden.

Gemäß Anspruch 7 kann für die Kontaktierung der Chips auch die Flipchip-Technik mit Erfolg eingesetzt werden.

Bei der Flipchip-Kontaktierung können gemäß Anspruch 8 zur Direktverbindung der Chipanschlüsse mit den zugeordneten Innenanschlüssen die Chipanschlüsse als schmelzfähige Höcker ausgebildet werden.

Gemäß Anspruch 9 können bei der Flipchip-Kontaktierung aber auch die Innenanschlüsse durch beim Spritzgießen des Substrats mitgeformte und mit einer lötbare Endoberfläche versehene Polymerhöcker gebildet werden. Hierdurch können einerseits normale Chips ohne schmelzfähige Höcker verwendet werden, während andererseits die Herstellung und Metallisierung der Polymerhöcker bei der MID Technologie praktisch ohne zusätzlichen Aufwand durchgeführt werden kann. Die Polymerhöcker haben zusätzlich den Vorteil, daß sie einen elastischen Ausgleich zwischen unterschiedlichen Ausdehnungsverhalten von Substrat und Chip erlauben.

Ausführungsbeispiele der Erfindung sind in der Zeichnung dargestellt und werden im folgenden näher beschrieben.

Es zeigen
- Figur 1: einen Schnitt durch ein Polymer Stud Grid Array mit einen in Drahtbond-Technik kontaktierten Chip,
- Figur 2: einen Schnitt durch ein Polymer Stud Grid Array mit einem gemäß einer ersten Ausführungsform in Flipchip-Technik kontaktierten Chip,
- Figur 3: einen Schnitt durch ein Polymer Stud Grid Array mit einem gemäß einer zweiten Ausführungsform in Flipchip-Technik kontaktierten Chip,
- Figur 4: einen Schnitt durch das Substrat des in Figur 1 dargestellten Polymer Stud Grid Arrays mit einer Draufsicht auf Außenanschlüsse, Leiterzüge und Innenanschlüsse und
- Figur 5: einen vergrößerten Ausschnitt der Figur 4 mit Außenanschlüssen, Leiterzügen und Innenanschlüssen.

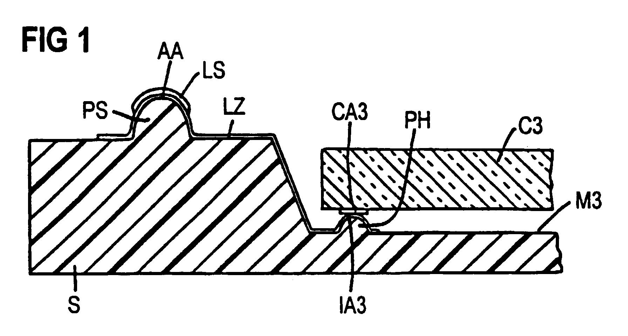

Figur 1 zeigt einen Schnitt durch einen Teil eines Polymer Stud Grid Arrays mit einem in Drahtbond-Technik kontaktierten Chip C1. Basis des dargestellten Arrays ist ein Substrat S, das mit "Polymer Studs" bzw. Polymerhöckern PS und einer Mulde M1 versehen ist, wobei die Mulde M1 eine mit ST bezeichnete Stufe aufweist. Die Herstellung des Substrats S einschließlich Polymerhöckern PS, Mulde M1 und Stufe ST, erfolgt durch Spritzgießen, wobei als Substratmaterialien hochtemperaturbeständige Thermoplaste, wie Polyetherimid, Polyethersulfon oder Liquid Cristalline Polymers geeignet sind.

Das in Figur 1 dargestellte Substrat S wird entsprechend der MID Technologie ganzflächig metallisiert und dann einem Laserstrukturierungsverfahren unterzogen, wobei als Ergebnis dieser Laserstrukturierung Außenanschlüsse AA auf den Polymerhöckern PS, Innenanschlüsse IA1 auf der Stufe ST und sich dazwischen erstreckende Leiterzüge LZ verbleiben. Die Außenanschlüsse AA sind im Kuppenbereich mit einer Lotschicht LS versehen, wobei diese Lotschicht LS beispielsweise durch eine Zinn-Blei-Legierung gebildet ist. Anstelle der Lotschicht LS, kann auch beispielsweise eine aus einer Schichtenfolge von Nickel und Gold bestehende lötbare Endoberfläche vorgesehen sein. Die auf der Stufe ST angeordneten Innenanschlüsse IA1 sind über Kontaktierdrähte KD mit den Anschlüssen CA1 des am Boden der Mulde M1 in Face up-Lage befestigten Chips C1 verbunden.

Das in Figur 1 dargestellte Polymer Stud Grid Array wird mit den auf den Polymerhöckern PS gebildeten Außenanschlüssen AA nach unten auf einer nicht dargestellten Leiterplatte oder Baugruppe kontaktiert. Entgegen der in Figur 1 dargestellten Lage, handelt es sich also bei der Seite mit den Polymerhöckern PS um die Unterseite des Substrats S.

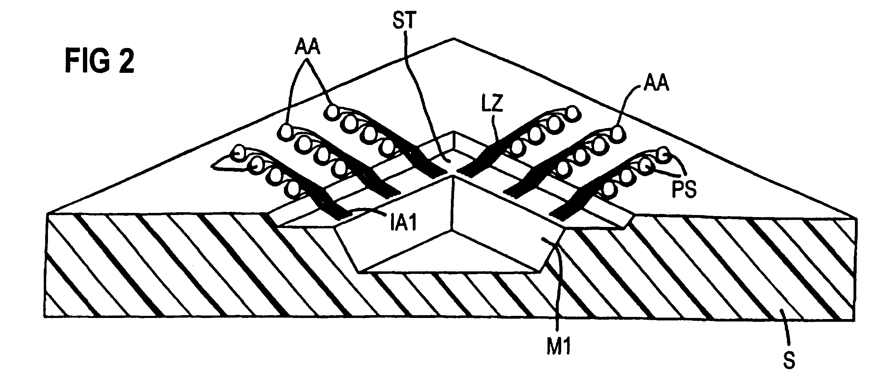

Figur 2 zeigt einen Schnitt durch einen Teil eines Polymer Stud Grid Arrays mit einem gemäß einer ersten Ausführungsform in Flipchip-Technik kontaktierten Chip C2. Im Unterschied zu Figur 1 liegen hier die mit IA2 bezeichneten Innenanschlüsse am Boden einer mit M2 bezeichneten Mulde. Der in Face down-Lage in der Mulde M2 angeordnete Chip C2 besitzt Chipanschlüsse CA2 in Form schmelzfähiger Höcker, die auf den zugeordneten Innenanschlüssen IA2 aufliegen und mit diesen beim Löten verbunden werden.

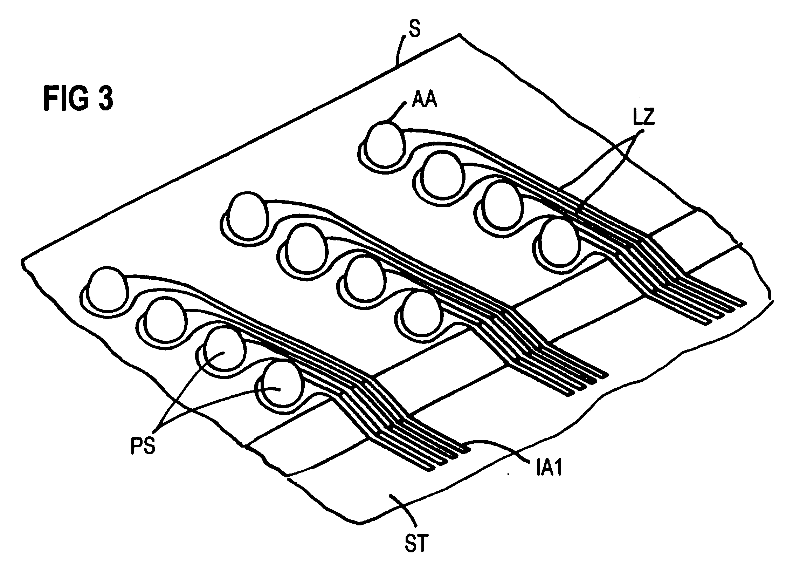

Figur 3 zeigt einen Schnitt durch einen Teil eines Polymer Stud Grid Arrays mit einem gemäß einer zweiten Ausführungsform in Flipchip-Technik kontaktierten Chip C3. Im Unterschied zu den Figuren 1 und 2 sind die hier mit IA3 bezeichneten Innenanschlüsse durch zusätzlich beim Spritzgießen des Substrats S im Bodenbereich der Mulde M3 mitgeformte und mit einer lötbaren Endoberfläche versehene Polymerhöcker PH gebildet. Die Polymerhöcker PH für die Innenanschlüsse IA3 weisen etwa ein Drittel des Volumens der Polymerhöcker PS für die Außenanschlüsse AA auf. Der in Face down-Lage in der Mulde M3 angeordnete Chip C3, liegt mit seinen Chipanschlüssen CA3 auf den zugeordneten Innenanschlüssen IA3 der Polymerhöcker PH auf und wird mit diesen durch Löten verbunden. Das hier nicht dargestellte Lot kann beispielsweise in Form einer im Kuppenbereich auf die Innenanschlüsse IA3 aufgebrachten Lotschicht bereitgestellt werden, in gleicher Weise, wie bei den Außenanschlüssen AA.

Die Figuren 4 und 5 zeigen Einzelheiten des in Figur 1 dargestellten Polymer Stud Grid Arrays, wobei das Substrat S hier jedoch vor der Befestigung des Chips C1 in der Mulde M1 dargestellt wurde. Es ist zu erkennen, daß die auf den Polymerhöckern PS gebildeten Außenanschlüsse AA reihenweise in einem feinen Raster angeordnet werden können. Die bei der MID Technologie übliche Laserfeinstrukturierung ermöglicht auch eine eng nebeneinanderliegende Anordnung der Leiterzüge LZ und der auf der Stufe ST liegenden Innenanschlüsse IA1.

Die vorstehend anhand der Figuren 1 bis 5 erläuterten Ausführungsbeispiele zeigen das Prinzip eines Polymer Stud Grid Arrays mit auf Polymerhöckern gebildeten Außenanschlüssen. Abweichend von der in der Zeichnung dargestellten Form können die Polymerhöcker auch andere Formen, wie z.B. eine Kegelstumpfform aufweisen. Obwohl jeweils nur ein Chip dargestellt wurde, kann die neue Bauform bei Single-, Few- oder Multi-Chip-Modulen angewandt werden. Die Chips können auch beispielsweise durch Ausgießen der Mulden oder durch die Anbringung von Deckeln verkapselt werden. Auf der Oberseite und den seitlichen Flächen des spritzgegossenen Substrats kann auch eine Metallisierungsschicht als elektromagnetische Abschirmung oder für eine gute Wärmeabfuhr verbleiben. Es ist jedoch auch möglich, das Substrat mit Durchkontaktierungen zu versehen, und auf der Oberseite eine zweite Verdrahtungslage anzuordnen. Auf dieser zweite Verdrahtungslage können nach dem Aufbringen entsprechender Dielektrikumsschichten auch weitere Leiterebenen nach Art einer Mehrlagenverdrahtung gebildet werden. Bei einem mit Durchkontaktierungen versehenen Substrat, können die Polymerhöcker und der Chip oder die Chips durchaus auch auf verschiedenen Seiten des Substrats angeordnet sein. Eine derartige Anordnung von Polymerhöckern und Chips auf gegenüberliegenden Seiten des Substrats ist insbesondere bei großen Chips, die eine Vielzahl von zugeordneten Außenanschlüssen benötigen, interessant.

## Patentansprüche

1. Verfahren zur Herstellung eines Substrats (S) für ein Polymer Stud Grid Array mit folgenden Schritten:
- Herstellung des dreidimensionalen Substrats (S) aus einem elektrisch isolierenden Polymer durch Spritzgießen, derart, daß auf der Unterseite des Substrats (S) flächig angeordnete und beim Spritzgießen mitgeformte Polymerhöcker (PS) entstehen;
- ganzflächige Metallisierung des Substrats (S);
- Bildung von Außenanschlüssen (AA) auf den Polymerhöckern (PS), von Innenanschlüssen (IA1; IA2; IA3) und von Leiterzügen (LZ) durch Laserstrukturierung der Metallisierung, wobei die zumindest auf der Unterseite des Substrats (S) ausgebildeten Leiterzüge (LZ) sich zwischen den Außenanschlüssen (AA) und den Innenanschlüssen (IA1; IA2; IA3) erstrecken;
- Aufbringen einer lötbaren Endoberfläche im Kuppenbereich der Polymerhöcker (PS).

2. Verfahren nach Anspruch 1, **dadurch gekennzeichnet,** daß auf dem Substrat (S) mindestens ein Chip (C1; C2; C3) angeordnet wird und daß die Anschlüsse (CA1; CA2; CA3) des Chips (C1; C2; C3) mit den Innenanschlüssen (IA1; IA2; IA3) elektrisch leitend verbunden werden.

3. Verfahren nach Anspruch 1 oder 2, **dadurch gekennzeichnet,** daß das Substrat (S) beim Spritzgießen mit einer Mulde (M1; M2; M3) versehen wird.

4. Verfahren nach den Ansprüchen 2 und 3, **dadurch gekennzeichnet,** daß der Chip (C1; C2; C3) in der Mulde (M1; M2; M3) des Substrats (S) angeordnet wird.

5. Verfahren nach Anspruch 4, **dadurch gekennzeichnet,** daß der Chip (C1) in Face up-Lage in der Mulde (M1) angeordnet wird und daß die Anschlüsse (CA1)des Chips (C1) über Kontaktierdrähte (KD) mit den zugeordneten Innenanschlüssen (IA1) elektrisch leitend verbunden werden.

6. Verfahren nach Anspruch 5, **dadurch gekennzeichnet,** daß die Mulde (M1) beim Spritzgießen des Substrats (S) mit einer Stufe (ST) versehen wird und daß die Innenanschlüsse (IA1) auf der Stufe (ST) angeordnet werden.

7. Verfahren nach Anspruch 4, **dadurch gekennzeichnet,** daß die Innenanschlüsse (IA2; IA3) am Boden der Mulde ((M2; M3) angeordnet werden, daß der Chip (C2; C3) in Face down-Lage in der Mulde (M2; M3) angeordnet wird und daß die Anschlüsse (CA2; CA3) des Chips (C2; C3) mittels Flipchip-Kontaktierung mit den Innenanschlüsse (IA2; IA3) elektrisch leitend verbunden werden.

8. Verfahren nach Anspruch 7, **dadurch gekennzeichnet,** daß die Anschlüsse (CA2) des Chips (C2) als schmelzfähige Höcker ausgebildet werden.

9. Verfahren nach Anspruch 7, **dadurch gekennzeichnet,** daß beim Spritzgießen des Substrats (S) zusätzliche Polymerhöcker (PH) mitgeformt werden und daß die zusätzlichen Polymerhöcker (PH) zur Bildung der Innenanschlüsse (IA3) mit einer lötbaren Endoberfläche versehen werden.
